Europäisches Patentamt

European Patent Office

Office européen des brevets

(11) Publication number : **0 507 718 A1**

## (12) EUROPEAN PATENT APPLICATION

(21) Application number : **92480042.8**

(22) Date of filing : **13.03.92**

(51) Int. Cl.⁵ : **B23K 35/26,** B23K 35/00,
// H01L21/60

(30) Priority : **04.04.91 US 680206**

(43) Date of publication of application :
**07.10.92 Bulletin 92/41**

(84) Designated Contracting States :
**DE FR GB**

(71) Applicant : **International Business Machines
Corporation
Old Orchard Road
Armonk, N.Y. 10504 (US)**

(72) Inventor : **Agarwala, Birendra Nath
56 Saddle Ridge Drive
Hopewell Junction, New York 12533 (US)**

Inventor : **Gonya, Stephen Gilberg
Ivory Garden Apartments, Apt. B8
Owego, New York 13827 (US)**
Inventor : **Lake, James Kenneth
620 West Wendell Street
Endicott, New York 13760 (US)**
Inventor : **Long, Randy Clinton
Box 34A, R.R. 1
Friendsville, Pennsylvania 18818 (US)**
Inventor : **Roeder, Jeffrey Frederick
4 Longmeadow Hill Road
Brookfield, Connecticut 06804 (US)**
Inventor : **Wild, Roger Neil
3360 Day Hollow Road
Owego, New York 13827 (US)**

(74) Representative : **Colas, Alain
Compagnie IBM France Département de
Propriété Intellectuelle
F-06610 La Gaude (FR)**

(54) Low lead content Pb-Sn-Ag-Sb solder alloy useful in an interconnect metallization structure.

(57)    A solder alloy consisting essentially of 61%-68% tin, 0.2%-3.9% silver, 0.5%-1.5% antimony, and the remainder lead.
   A metallization structure structure, comprising : a metal adhesion layer ; a metal conduction layer on said adhesion layer ; a metal barrier layer on said conduction layer ; and, a solder alloy layer consisting essentially of 61%-68% tin, 0.2%-3.9% silver, 0.5%-1.5% antimony, and the remainder lead, over said conduction layer.

FIG. 3

The present invention relates generally to metal alloys, and more particularly to a quaternary solder alloy including a high percent content of tin and a low percent content of lead, and an interconnect metallization structure incorporating this quaternary solder alloy.

Low dielectric polymer materials such as polyimide are increasingly used as insulating and passivating layers in semiconductor chip packaging. Useful for their insulating characteristics, these materials require low temperature processing to prevent their degradation.

Solder joining of semiconductor dies utilizing polyimide insulator thus requires low temperature processes and solders. However, with low temperature solders, the operating temperatures of the soldered, interconnect metallization structures comprise a higher fraction of the solder melting temperature, and thermally-activated degradation of the solder material becomes a problem.

More particularly, this degradation typically comprises excessive creep, and excessive electromigration. Excessive creep, exacerbated by the pressure load of a heat sink, can lead to failure by shorting of adjoining interconnect metallization structures. Excessive electromigration, caused by high current densities, can result in open circuits and mechanical failures of the interconnect metallization structure.

In addition to creep and electromigration, failure due to fatigue can result from thermal cycling combined with even minor mismatches between the coefficients of thermal expansion of the interconnect metallization structure and the substrates or dies.

The use of lead/tin solder alloys is well known in the art for interconnect metallization structures of the type discussed herein. Lead/tin alloys present a trade-off, however, in that high concentrations of lead (lead > 90%) result in alloys having undesirably high melting points and desirably low creep, while low concentrations of lead (lead < 90%) result in alloys having a lower melting point but an undesirably high creep.

There are, of course, other applications in which creep, electromigration, and fatigue are not problems, or in which these characteristics, albeit undesirable in chip joining, can be accommodated to optimize other desirable alloy characteristics, such as a low melting temperature. Accordingly, a large variety of metal alloys have been proposed in the art, depending on the desired end results.

See, for example, the following references:

US-Re. 29,563 to Manko teaches the use of solder alloys of 50-57.5% tin, 1.5-4% antimony, the remainder lead, as a low-temperature melting point substitute for the more expensive, eutectic 63% tin, 37% lead;

US-A-4,740,099 to Philipoussi shows a mechanism utilizing "peel-off" soldered, metal plates connected with a solder alloy of 62% tin, 36% lead, 2% silver;

US-A-4,608,230 to DiMartini et al. shows the use of a solder alloy of 87.5-96.5% lead, 3-10% tin, 0.5-2.0% antimony, and 0-0.5% silver, selected for its resistance to galvanic corrosion and its solderability, and which is particularly useful in automotive radiator applications;

US-A-3,574,925 to Schneider et al. shows the use of a solder alloy of 60% tin, 36% lead, 4% silver, selected for its softness and reproducible results in an automated soldering process;

Japanese Kokoku no. 61-56,542 by Senju Kinzoku Kogyo KK shows the use of a solder alloy of 15-65% tin, 0.5-3.5% silver, 3.0-10% antimony, remainder lead, selected for its particular suitability for soldering silver leads (this reference specifically teaches against the use of less than 3% antimony, so as to maintain bonding strength following heat treatment);

US-A-4,070,192 to Arbib et al. shows the use of a solder alloy comprising at least 35% lead, 10% tin, x% silver, where x is a function of the wt% tin, the solder alloy being optimized with respect to the joining of aluminum members;

US-A-3,508,118 to S. Merrin et al. shows the use of high lead content solders, e.g.. 97.5% lead, 2.5% tin, for soldering in circuits;

US-A-4,937,045 to Silverman shows the use of a solder alloy of 51-56% tin, trace-1% antimony, and balance lead, optimized to facilitate high-speed, decorative, hand soldering; and

US-A-3,644,115 to Hamaguchi et al. shows the use of a solder alloy of tin, lead, and 0.005-0.2% aluminum, the aluminum added to improve oxidation resistance.

Ball-limiting metallurgy (BLM) structures are known which utilize current-spreading layers to minimize undesired electromigration. US-A-4,514,751 to Bhattacharya (assigned to the assignee of the present invention), for example, uses a conductive copper layer in a BLM structure to spread current and reduce electromigration in high current density applications.

Despite the large numbers of solder alloys known for various types of applications, the need exists for a solder alloy which provides a low melting temperature, while minimizing the undesirable characteristics of creep, electromigration, and fatigue. Such a solder alloy would be useful in an interconnect metallization structure for the type of semiconductor chip package wherein temperature-sensitive polyimide is used as an insulator, and wherein pressure compression of the interconnect metallization structure results from the mechanical pressure of a heat sink.

2

An object of the present invention is to provide a solder alloy exhibiting a low melting temperature and high resistance to creep.

Another object of the present invention is to provide an interconnect metallization structure incorporating such a solder alloy and which utilizes the beneficial properties of the solder alloy in combination with a ball limiting metallurgy to minimize electromigration.

A further object of the present invention is to provide such an interconnect metallization structure which is relatively inexpensive in construction and utilizes a minimum number of metal layers.

Yet another object of the present invention is to provide such a solder alloy, and an interconnect metallization structure using this solder alloy, which are suitable for joining chip dies including polyimide passivation layers.

In accordance with one aspect of the present invention, there is provided a solder alloy consisting essentially of 61%-68% tin, 0.2%-3.9% silver, 0.2%-1.5% antimony, and the remainder lead.

In accordance with another aspect of the present invention, there is provided an interconnect metallization structure, comprising: a metal adhesion layer; a metal conduction layer on said adhesion layer; a metal barrier layer on said conduction layer; and, a solder alloy layer consisting essentially of 61%-68% tin, 0.2%-3.9% silver, 0.5%-1.5% antimony, and the remainder lead, over said conduction layer.

These and other objects, features, and advantages of the present invention will become apparent upon consideration of the following detailed description of the invention, and drawing Figures, in which:

FIG. 1 is a plan view of a portion of a semiconductor chip package incorporating the present invention;

FIG. 2 is an enlarged, cross-sectional view of the interconnect metallization structure of FIG. 1, in an as-deposited condition; and

FIG. 3 is an enlarged, cross-sectional view of the interconnect metallization structure of FIG. 1 after chip/substrate joining is completed.

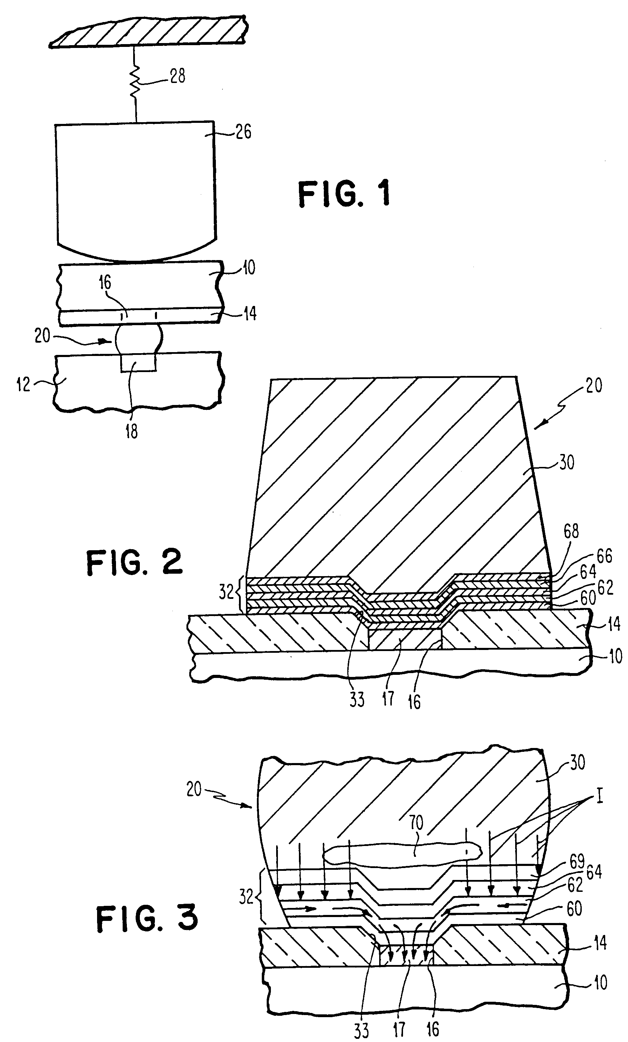

Referring now to FIG. 1, a small section of a semiconductor chip package is shown including a joined semiconductor chip 10 and substrate 12. Chip 10 includes an overlying passivating layer 14 of polyimide, and a metal-filled via 16 extending between the chip and a surface of the insulating layer. An interconnect metallization structure 20 electrically connects metal-filled via 16 to a metal, electrical distribution layer 18 on substrate 12. A heatsink/piston 26 is held by pressure against the back surface of chip 10 using a compression spring 28.

As described in the Background above, polyimide layer 14 has a relatively low transition temperature, making it subject to thermal degradation. It is thus necessary to achieve the chip/substrate joining described above, via wetting of a solder in interconnect metallization structure 20, at a relatively low temperature, i.e. below about 250 degrees centigrade. However, because of the pressure exerted by spring 28 through piston 26, it is also necessary for interconnect metallization structure 20 to be resistant to creep.

Referring now to FIG. 2, an enlarged, cross-sectional view of interconnect metallization structure 20 is shown, formed in accordance with the present invention, and before chip 10 and substrate 12 have been joined to yield the characteristic "solder ball" shape visible in FIG. 1. Briefly, interconnect metallization structure 20 includes a layer of quaternary solder alloy 30 deposited over a five layer metal stack 32. Metal stack 32 is known in the art as a Ball Limiting Metallurgy (BLM). Visible in enlarged FIGS. 2 and 3 is a chamfer edge 33 of metal-filled via 16. As is best shown in these same FIGS., the metal filling via 16 includes a metal line 17 disposed on the surface of chip 10 within the via, and portions of metal stack 32 that extend into the via into contact with the metal line.

Describing first solder alloy 30, the present inventors have discovered a quaternary alloy which optimizes the desired characteristics of low melting temperature and high resistance to creep. More specifically, this alloy comprises 61-68% tin (Sn), 0.2-3.9% silver (Ag), 0.2-1.5% antimony (Sb), and the remainder lead (Pb). As used herein, all "%" measurements represent percent by weight.

The Table set out below illustrates the results of experimental creep and fatigue testing on various solder alloys. The test designated as Creep1 measures the steady state creep rate in a bulk tensile specimen: 0.15″ dia., 1.25″ gage length, at 565 psi, and 100 degrees C. The test designated as Creep2 measures the steady state creep rate under a compressive load on a specimen: 0.006″ dia. sphere, at 200 psi, and 80 degrees C. The test designated as Fat. measures the fatigue life of a specimen: 0.100″ dia., 0.125″ gage length, at 5 cycles/minute, and 4.3% strain, with delta-R = 0.3 milliohms as a failure criteria.

## Table

| | --Composition (%wt)- | | | | Liq. | Sol. | Crp1 | Crp2 | Fat. |
|---|---|---|---|---|---|---|---|---|---|
| No. | Sn | Pb | Ag | Sb | C | C | - | - | #cls |
| 1 | 61.9 | 38.1 | - | - | 182 | 182 | 492.0 | * | 300 |
| 2 | 61.8 | 38.0 | 0.2 | - | 183 | 179 | 225.0 | * | 400 |
| 3 | 61.4 | 37.8 | 0.8 | - | 180 | 180 | 88.5 | * | 425 |
| 4 | 61.2 | 37.6 | 1.2 | - | 179 | 179 | 87.1 | * | 517 |
| 5 | 60.7 | 37.4 | 1.9 | - | 179 | 179 | 33.0 | * | 400 |
| 6 | 59.4 | 36.7 | 3.9 | - | 179 | 179 | 52.9 | * | 245 |
| 7 | 61.8 | 38.0 | - | 0.2 | 183 | 183 | 507.0 | * | 375 |
| 8 | 61.4 | 37.8 | - | 0.8 | 184 | 184 | 433.7 | * | 225 |
| 9 | 61.2 | 37.6 | - | 1.2 | 184 | 184 | 290.3 | * | 325 |
| 10 | 60.7 | 37.4 | - | 1.9 | 185 | 185 | 150.0 | * | 208 |
| 11 | 68.6 | 29.4 | - | 2.0 | * | * | * | 4.8 | * |
| 12 | 59.4 | 36.7 | - | 3.9 | 190 | 187 | 33.3 | * | 120 |
| 13 | 61.8 | 36.3 | 1.7 | 0.2 | 179 | 179 | 22.5 | 3.7 | 426 |
| 14 | 61.7 | 35.8 | 2.0 | 0.5 | 180 | 180 | 15.3 | * | 372 |
| 15 | 61.4 | 35.6 | 2.0 | 1.0 | 180 | 180 | 15.0 | * | 341 |
| 16 | 61.0 | 35.5 | 2.0 | 1.5 | 181 | 181 | 4.1 | 2.1 | 263 |
| 17 | 67.5 | 29.0 | 2.0 | 1.5 | * | * | * | 2.6 | * |

Table Key: "-" = not tested, "*" = data not available,
"No." = alloy, "Liq" = liquidus temp (degrees C),
"Sol" = solidus temp (degrees C),
"Crp1" = first creep test, units = $10^{-2}$/sec,
"Crp2" = second creep test, units = $10^{-2}$/sec,
"#cls" = no. of thermal cycles to fatigue failure

Evaluating the results of the Table of experimental data set out above, binary alloy 1 (61.9% Sn, 38.1% Pb) has a low melting temperature, but poor resistance to creep. The addition of Ag, shown in tertiary alloys 2-6 in amounts generally from 0.2-3.9%, substantially reduces the creep rate of the alloy, but still not to a level desirable for an interconnect metallization structure of the type described above. The substitution of Sb for the Ag, shown in tertiary alloys 7-12, and particularly in amounts greater than 0.2% (i.e. tertiary alloys 8-12), also reduces the creep rate of the alloy, but again not to a desirable level. Also with the tertiary alloy including Sb, as the creep rate drops, the fatigue life shortens (see specifically alloys 10 and 12, and the relatively short fatigue lives associated therewith).

Looking now at the quaternary alloys 13-17, the present inventors have discovered that the addition of both Ag and 0.2-1.5% Sb produce alloys having unexpectedly low creep, a melting point lower than binary alloy 1, and fatigue lives ranging from better than the binary alloy (see quaternary alloys 13-15) to not substantially less than the binary alloy (see quaternary alloy 16).

Based on the performance of tertiary alloys 2-6, the present inventors have determined that the described quaternary alloys will exhibit the desirable operating characteristics for Ag in the range of 0.2-3.9%, with the optimum performance being obtained with the 2% Ag shown in alloys 14-17.

Describing now metal stack 32, an adhesion layer 60, selected for its ability to adhere to the metal of line 17 in via 16 and the surface of insulator layer 14 adjoining the via, is deposited directly over the via. Where metal line 16 comprises an Al-Cu alloy, adhesion layer 60 can comprise chromium, titanium, tantalum, or tungsten. A conduction layer 62, selected for its ability to conduct current, and comprising, for ex:male, copper, nickel, or cobalt, is deposited over adhesion layer 60.

Continuing to describe metal stack 32, a barrier layer 64, selected for its ability to prevent tin interdiffusion so as to prevent a reaction of tin with the conductive layer, and comprising, for example, chromium, titanium, tantalum, or tungsten, is deposited over conduction layer 62. A solder-wettable metal layer 66, selected for its ability to wet solder layer 30, is deposited over barrier layer 64. Layer 66 can comprise, for example, cobalt, copper, or nickel. Finally, a protective layer 68, selected to prevent oxidation of the wettable metal layer 66, and for example comprising gold, is deposited over solder-wettable layer 66.

The interconnect metallization structure layers, including stack 32 and solder alloy 30, are deposited onto metal line 17 and the surrounding region of polyimide layer 14, using well-known methods, through, for example, a metal mask (not shown). A similar BLM structure (not shown) is desirably formed over metal line 18 in FIG. 1.

The structure as shown in FIG. 2 is then placed in a furnace and heated at a temperature in the range of 20-40 degrees C above the melting point of solder alloy 30, whereby to melt solder alloy 30 into a characteristic ball shape. Chip 10 is then aligned to substrate 12, via interconnect metallurgy 20 in the manner shown in FIG. 1, and heated again to join chip 10/metal line 16 to substrate 12/metal line 18 through solder 30. An appropriate solder flux, such as abiatic acid (not shown), is preferably used prior to these last alignment and heating steps.

Referring now to FIG. 3, a cross-sectional view of the metallization structure of FIG. 2 is shown, after chip joining is completed in the manner described above. Layers 66 and 68 have combined with solder alloy from layer 30 to form an intermetallic layer 69. As is further shown, a void 70 may subsequently form inside interconnect metallization structure 20 due to electromigration. In accordance with another feature of the present invention, when current I (illustrated by arrows in FIG. 3) flows through collapsed interconnect metallization structure 20, conduction layer 62 tends to force this current to be equally distributed amongst upper layers 64, 69, and 30. The current is then collected by conduction layer 62 and flows through layer 60 to metal line 16.

This distribution of current has the significant advantage of preventing electromigration-induced high current densities from forming at the edges of void 70, which would eventually cause failure. Such failures are typical in the prior art.

There has thus been provided a new and improved solder alloy, and a new and improved interconnect metallization structure which utilizes this solder alloy to advantage in a chip mounting package. The solder alloy has the beneficial characteristics of low melting temperature in combination with resistance to creep. The interconnect metallization structure incorporating the solder alloy is resistant to failure by electromigration. Both the solder alloy and the interconnect metallization structure can be fabricated using conventional semiconductor fabrication materials and processes. Further, the interconnect metallization structure is relatively inexpensive and straightforward to fabricate in comparison to the complex structures of the prior art.

The present invention has applicability in soldering environments wherein it is desired to minimize creep, while maintaining a relatively low melting temperature. Such environments include lead soldering of gull-wing packages, and chip joining packages of the type described herein. The invention has particular application in high power chip packages utilizing pressure-mounted chips and heat sinks, of the type used to package very large scale integrated (VLSI) circuits.

While specific embodiments of the present invention have been shown and described, the invention is not thusly limited. In particular, numerous modifications, changes and improvements will occur to those skilled in the art which fall within the scope of the present invention.

## Claims

1. A solder alloy consisting essentially of 61%-68% tin, 0.2%-3.9% silver, 0.5%-1.5% antimony, and the remainder lead.

2. The solder alloy of claim 1, the concentration of said silver being 1.7-2.0%.

3. A metallization structure structure, comprising:
a metal adhesion layer;
a metal conduction layer on said adhesion layer;
a metal barrier layer on said conduction layer; and

a solder alloy layer consisting essentially of 61%-68% tin, 0.2%-3.9% silver, 0.5%-1.5% antimony, and the remainder lead, over said conduction layer.

4. The structure of claim 3 and further including a metal solder-wettable layer intermediate said barrier and solder alloy layers.

5. The structure of claim 4, and further including a protective layer intermediate said solder-wettable and solder alloy layers.

6. The structure of claim 5 wherein:
said adhesion layer is selected from the group consisting of chromium, titanium, tantalum, and tungsten;
said conduction layer is selected from the group consisting of copper, nickel, and cobalt;
said barrier layer is selected from the group consisting of chromium, titanium, tantalum, and tungsten; and
said solder-wettable layer is selected from the group consisting of copper, nickel, and cobalt.

7. The solder alloy of claim 3, the concentration of said silver being 1.7-2.0%.

**FIG. 1**

28

26

10

16

14

20

12

18

**FIG. 2**

20

30

68

66

64

62

60

32

14

10

33 17 16

**FIG. 3**

20

30

I

70

69 64

62

60

32

14

10

33 17 16

## European Patent Office

## EUROPEAN SEARCH REPORT

Application Number

EP    92 48 0042

### DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| X | PATENT ABSTRACTS OF JAPAN vol. 6, no. 26 (M-112)(904) 16 February 1982 & JP-A-56 144 893 ( SENJIYU KINZOKU KOGYO ) 11 November 1981 | 1,2 | B23K35/26 B23K35/00 // H01L21/60 |
| Y | * abstract * | 3-6 | |
| X | FR-A-1 603 977 (ANGLADE & CIE) 30 July 1971 * page 4 * | 1 | |
| X | GB-A-2 216 834 (TOYOTA MOTOR CORP.) 18 October 1989 * claims 1,3,4,6; table 2 * | 1 | |
| Y | DE-A-3 523 808 (HITACHI) 16 January 1986 * page 25 – page 30; claims 1,4,6,10 * | 3-6 | |
| A | EP-A-0 398 485 (PLESSEY OVERSAES) 22 November 1990 | 3,6 | |
| A | EP-A-0 374 475 (INTERNATIONAL BUSINESS MACHINES) 27 June 1990 | 3 | TECHNICAL FIELDS SEARCHED (Int. Cl.5) |
| A,D | EP-A-0 111 823 (INTERNATIONAL BUSINESS MACHINES) 27 June 1984 | | B23K |
| A | GB-A-555 844 (BRITISH NON-FERROUS METALS RESEARCH ASSOCIATION) 9 September 1943 | 1 | |

The present search report has been drawn up for all claims

| Place of search | Date of completion of the search | Examiner |
|---|---|---|
| THE HAGUE | 23 JULY 1992 | MOLLET G.H. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document